# EUROPÄISCHE PATENTSCHRIFT

(11) **EP 3 941 773 B1**
(45) Veröffentlichungstag und Bekanntmachung des Hinweises auf die Patenterteilung: **09.08.2023**
(21) Anmeldenummer: 20713845.4
(22) Anmeldetag: 11.03.2020
(51) Int. Cl.: B60K 35/00, B60K 37/06, H03K 17/96

(54) **FAHRZEUGZIERTEIL**
VEHICLE TRIM ELEMENT
ÉLÉMENT DE GARNISSAGE DE VÉHICULE

(30) Priorität: 22.03.2019 DE 102019107358
(43) Veröffentlichungstag der Anmeldung: 26.01.2022
(73) Patentinhaber: HIB Trim Part Solutions GmbH, 76646 Bruchsal (DE)
(72) Erfinder: YU, Zhikai, 76646 Bruchsal (DE); SCHNABEL, Uwe, 76646 Bruchsal (DE)
(74) Vertreter: Staeger & Sperling Partnerschaftsgesellschaft mbB
(86) Internationale Anmeldenummer: PCT/EP2020/056452
(87) Internationale Veröffentlichungsnummer: WO 2020/193135

(56) Entgegenhaltungen:
- DE-A1-102012 101 315
- DE-A1-102015 002 966
- DE-A1-102016 211 074
- US-A1- 2017 228 126

## Beschreibung

Die Erfindung betrifft ein Fahrzeugzierteil mit Anzeige- und Bedienfunktionalität, insbesondere für den Innenraum eines Kraftfahrzeugs.

Gattungsbildende Zierteile sind üblicherweise ein reines Designelement im Fahrzeuginnenraum, beispielsweise mit einer Holzfurnieroptik oder einer Aluminiumoptik auf der in den Fahrgastraum weisenden Sichtseite. Soweit zusätzlich technische Anzeigen oder Bedienelemente integriert werden sollen, sind hierzu meist Displays und Touchsensoren im Einsatz. Diese werden auch mit den Zierteilen kombiniert.

Alternativ zu Displays werden Symbole teilweise rückseitig auf Schichten des

Zierteils projiziert, wobei die so dargestellten Symbole meist unscharf und ohne klare Abgrenzung erscheinen, so dass diese schlecht erkennbar und ablesbar sind.

Wenn Displays und Touchsensoren oder eine Projektion und Touchsensoren für einen bzw. in einem Bereich des Zierteils kombiniert werden sollen, verschlechtert sich meist die Empfindlichkeit der Touchsensoren oder die Güte der Darstellung der Symbole.

Bei anderen Lösungen, durch welche Bedien- und Anzeigefunktionalitäten in Zierteile bzw. Fahrzeugzierteile integriert sind, sind diese in einem ungenutzten bzw. abgeschalteten Zustand meist sichtbar, so dass das optische Erscheinungsbild des Fahrzeugzierteils gestört und das Design des Fahrzeugzierteils negativ beeinflusst wird.

Fahrzeugzierteile teils mit darin integrierten Anzeigeelementen sind beispielsweise aus den Dokumenten US 2017/228126 A1, DE 10 2012 101 315 A1 und DE 10 2016 211 074 A1 bekannt.

Der Erfindung liegt deshalb die Aufgabe zugrunde, die vorgenannten Nachteile zu überwinden und ein Fahrzeugzierteil bereitzustellen, das auf dessen Sichtseite Bedien- und Anzeigefunktionen bereitstellt und das zugleich ein optisch ungestörtes Erscheinungsbild bietet, wenn die Anzeigefunktionen deaktiviert sind bzw. nicht genutzt werden, wobei die durch die Anzeigefunktion bereitgestellten Informationen scharf dargestellt und einfach ablesbar sein sollen.

Diese Aufgabe wird durch die Merkmalskombination gemäß Patentanspruch 1 gelöst.

Erfindungsgemäß wird ein Fahrzeugzierteil mit integrierter Anzeige- und Bedienfunktion vorgeschlagen, welches dadurch als Benutzerschnittstelle bzw. Mensch-Maschine-Schnittstelle (HMI) dienen kann. Das erfindungsgemäße Fahrzeugzierteil umfasst ein rückseitiges Trägerelement zur Befestigung des Fahrzeugzierteils an einem Fahrzeug und gegenüberliegend eine transparente Schutzschicht, welche eine Außenfläche des Fahrzeugzierteils und im bestimmungsgemäßen Gebrauch eine von dem Trägerelement abgewandte Sichtseite des Fahrzeugzierteils bildet. Zwischen der Schutzschicht und dem Trägerelement sind im Sandwichaufbau ausgehend von der Schutzschicht zumindest eine lichtdurchlässige Zierschicht, eine Maskierungsschicht, eine transparente Sensorschicht und eine Beleuchtungsschicht angeordnet. Die Maskierungsschicht weist transparente Bereiche auf, die Beleuchtungsschicht umfasst Beleuchtungselemente. Die Beleuchtungselemente sind ausgebildet, die transparente Sensorschicht und die transparenten Bereiche der Maskierungsschicht hin zu der Schutzschicht zu durchleuchten und die Sensorschicht ist ausgebildet, eine von der Sichtseite aus auf die Schutzschicht aufgebrachte Berührung zu erfassen, so dass durch eine Durchleuchtung der Maskierungsschicht mit den Beleuchtungselementen die Anzeigefunktion und durch eine Erfassung der Berührung mit der Sensorschicht die Bedienfunktion bereitstellbar sind.

Dier Berührung kann beispielsweise eine Berührung des Fahrzeugzierteils durch den Finger des Benutzers sein. Dadurch, dass die Sensorschicht nach der Maskierungsschicht und die Beleuchtungsschicht hinter der Sensorschicht angeordnet sind, ist eine auf die Sichtseite aufgebrachte Berührung mit hoher Empfindlichkeit erfassbar, wobei die Berührung vorzugsweise durch die Detektion eines aufgebrachten Drucks oder durch die Detektion einer kapazitiven Änderung erfasst wird. Zugleich sind Symbole, welche als Anzeigefunktion dargestellt werden, scharf darstellbar, da die Maskierungsschicht direkt hinter der Zierschicht angeordnet ist.

Zwischen der Zierschicht, der Maskierungsschicht, der Sensorschicht und der Beleuchtungsschicht kann jeweils eine transparente Klebeschicht angeordnet sein, welche jeweils vorzugsweise eine Dicke zwischen 0,01 und 0,20 mm, insbesondere zwischen 0,05 und 0,10 mm aufweist.

Die transparente Sensorschicht kann mehrere weitere Schichten bzw. Lagen umfassen, wie es aus der Anmeldung WO 2018 / 234 627 A1 bekannt ist.

Zwischen der Maskierungsschicht und der Sensorschicht oder zwischen der Sensorschicht und der Beleuchtungsschicht kann zudem jeweils eine vorzugsweise aufgedruckte Leiterschicht angeordnet sein, welche jeweils Leiterbahnen umfasst. Eine zwischen der Maskierungsschicht und der Sensorschicht angeordnete Leiterschicht ist mit ihren Leiterbahnen mit der Sensorschicht kontaktiert und ausgebildet, die Sensorschicht mit Strom zu versorgen sowie elektrische Signale der Sensorschicht zu leiten. Eine zwischen der Sensorschicht und der Beleuchtungsschicht angeordnete Leiterschicht ist mit ihren Leiterbahnen mit der Sensorschicht und/oder mit der Beleuchtungsschicht kontaktiert und ausgebildet, die Sensorschicht und/oder die Beleuchtungsschicht bzw. die Beleuchtungselemente der Beleuchtungsschicht mit Strom zu versorgen sowie elektrische Signale der Sensorschicht zu leiten.

Eine vorteilhafte Weiterbildung sieht vor, dass die Maskierungsschicht intransparente bzw. nicht-transparente Bereiche aufweist und die intransparenten und transparenten Bereiche der Maskierungsschicht eine Maske bzw. eine Schablone bilden, welche ein Negativ zumindest eines Symbols bestimmt. Durch die Durchleuchtung der Maske mit den Beleuchtungselementen ist das Symbol bzw. die Symbole an eine zu der Rückseite gewandte Seite der Zierschicht projizierbar, wobei das an die Rückseite der Zierschicht projizierte Symbol durch die Zierschicht hindurch an einer zu der Sichtseite weisenden Vorderseite der Zierschicht sichtbar ist. Die transparenten Bereiche können alternativ auch teiltransparent ausgebildet sein.

Bei der Projektion kommt vorzugsweise keine Linse zum Einsatz. Die Maske dient als Schablone für die darzustellenden Symbole, so dass die Symbole durch das von den Beleuchtungselementen emittierte Licht scharf begrenzt an der zu der Rückseite gewandten Seite der Zierschicht dargestellt werden, da von der zu der Sichtseite gewandten Vorderseite der Zierschicht nur das Licht und damit die von dem Licht dargestellten Symbole, die durch die Schablone bzw. der Maske bestimmt werden, sichtbar sind. Die Symbole können dabei durch eine transparente Klebeschicht oder andere transparente Schichten zwischen Maske und der Zierschicht hindurch projiziert werden, wobei die Maske auch unmittelbar an der Zierschicht angeordnet sein kann.

Ein Beleuchtungselement kann hierfür einem Symbol oder mehreren Symbolen zugeordnet sein. Zudem können einem Symbol auch mehrere Beleuchtungselemente zugeordnet sein.

Vorzugsweise ist vorgesehen, dass die Maske das Negativ einer Vielzahl von Symbolen bestimmt, die Symbole verschiedene Anzeigeelemente bilden und ein im Bereich eines jeweiligen Symbols von der Sichtseite aus auf die Schutzschicht aufgebrachte Berührung dem jeweiligen Symbol und einer Bedienfunktion zuordenbar ist.

Soll durch ein Symbol bzw. im Bereich eines Symbols eine reine Anzeigefunktion ohne Bedienfunktion bereitgestellt werden, kann die Berührung im Bereich dieses Symbols nicht erfasst werden oder eine in diesem Bereich erfasste Berührung keiner Bedienfunktion zugeordnet werden.

Bei einer vorteilhaften Variante ist vorgesehen, dass die Zierschicht eine vorbestimmte Opazität aufweist, welche so gewählt ist, dass die transparenten Bereiche der Maskierungsschicht durch die Zierschicht hindurch nicht von den intransparenten Bereichen unterscheidbar sind, wenn die Beleuchtungselemente die transparenten Bereiche der Maskierungsschicht nicht durchleuchten bzw. die transparenten Bereiche der Maskierungsschicht nicht durch die Beleuchtungselemente durchleuchtet sind. Dadurch ergibt sich, dass das Symbol oder die Symbole, die durch die Maske der Maskierungsschicht bestimmt sind, ohne eine Durchleuchtung der Maskierungsschicht mit den Beleuchtungselementen von der Sichtseite aus nicht sichtbar sind, wobei die Zierschicht insbesondere eine homogen erscheinende Fläche zur Sichtseite hin bereitstellt, welche durch verschiedene Druckmuster, eine vorbestimmte Materialanmutung oder grafische Designs gestaltet sein kann.

Um beispielsweise zum Aktivieren einer Bedien- und Anzeigefunktionalität einen haptisch erfassbares Bedienelement bereitzustellen oder für eine Bedienfunktionalität haptisch erfassbare Druck- bzw. Bedienpunkte zu definieren, ist bei einer vorteilhaften Ausbildungsvariante vorgesehen, dass die Schutzschicht einen sich zu der Sichtseite hin erstreckenden und haptisch oder optisch erfassbaren Vorsprung oder Bereich ausbildet. Ein solcher Vorsprung oder Bereich ist von der Sichtseite ausgesehen vorzugsweise über einem Symbol angeordnet und weist in der Draufsicht insbesondere die Form des Symbols, über welchem er angeordnet ist, auf, so dass der Vorsprung oder der Bereich durch das darunter liegende Symbol bzw. durch das dem Symbol zugeordnete Beleuchtungselement beleuchtbar ist. Als Variante eines haptisch erfassbaren Bereichs kann dieser beispielsweise auch aufgeraut sein oder einen Rücksprung in Richtung der Rückseite des Fahrzeugzierteils aufweisen. Als insbesondere optisch erfassbarer Bereich kann auch ein auf die Schutzschicht oder auf die Zierschicht aufgedrucktes Symbol verwendet werden. Bei der Verwendung eines Symbols ist dieses vorzugsweise zwischen der Schutzschicht und der Zierschicht auf eine der Schichten aufgedruckt, so dass es zu der Sichtseite hin von der Schutzschicht abgedeckt ist.

Um der auf die Sensorschicht aufgebrachten Berührung verschiedene Bedienfunktionalitäten zuordnen zu können, ist bei einer weiteren vorteilhaften Ausbildungsvariante vorgesehen, dass die Sensorschicht ausgebildet ist, einen Bereich, in dem die Berührung aufgebracht wird, zu erfassen. Dem Bereich, in dem die Berührung der Schutzschicht erfasst wird, können beispielsweise Koordinaten zugeordnet werden. Alternativ ist auch möglich, dass die Sensorschicht funktional oder physisch in mehrere Sensorbereiche aufgeteilt ist und beispielsweise jeweils ein Sensorbereich einem Symbol zugeordnet ist. Über ein an das Fahrzeugzierteil angeschlossenes Steuergerät kann dann den Koordinaten oder den Sensorbereichen eine Bedienfunktion zugeordnet sein.

Ferner ist die Sensorschicht vorzugsweise ausgebildet, die Berührung durch einen über die Schutzschicht auf die Sensorschicht aufgebrachten Druck oder durch eine kapazitive Änderung in einem zur Sichtseite an die Schutzschicht angrenzenden Nahbereich zu erfassen. Wird die Berührung über den Druck erfasst, wird dieser insbesondere durch die dazwischenliegenden Schichten von der Schutzschicht auf die Sensorschicht übertragen. Bei einer Erfassung über die kapazitive Änderung, wird die Kapazität bzw. die Änderung der Kapazität beispielsweise durch einen auf der Schutzschicht aufgelegten oder sich knapp über der Schutzschicht befindlichen Finger verursacht und registriert.

Die Maskierungsschicht und die Sensorschicht sind erfindungsgemäß miteinander als eine flexible Folie ausgebildet, wobei die Zierschicht und die Beleuchtungsschicht auf die Folie auflaminiert sind. Ein so gebildeter Schichtverbund ist auf das Trägerelement aufgeklebt oder mit dem Trägerelement hinterspritzt. Die Maskierungsschicht ist vorzugsweise auf die Sensorschicht aufgedruckt, wobei die intransparenten Bereiche beispielsweise durch schwarze, lichtundurchlässige Farbe und die transparenten Bereiche durch transparente bzw. teiltransparente Farbe gebildet werden. Die transparenten Bereiche können zudem verschiedene Farben aufweisen.

Die Beleuchtungsschicht kann auch durch die Lichtleitelemente und die Beleuchtungselemente gebildet werden, wobei die Lichtleitelemente nicht miteinander verbunden sein müssen. Die Beleuchtungsschicht kann daher auch durch mehrere, miteinander nicht direkt bzw. nur über das Trägerelement und die Sensorschicht verbundene Bereiche gebildet werden, welche jeweils zumindest ein Lichtleitelement und zumindest ein Beleuchtungselement aufweisen. Die Beleuchtungsschicht kann daher mehrteilig sein und kann die Sensorschicht nur abschnittsweise bedecken, wobei die einzelnen Teile bzw. Bereiche der Beleuchtungsschicht zueinander beabstandet sein können. Die einzelnen Teile bzw. Bereich der Beleuchtungsschicht sind vorzugsweise jeweils auf die Sensorschicht bzw. auf den Schichtverbund aufgeklebt oder auflaminiert.

Um die Symbole mit den Beleuchtungselementen an die Zierschicht projizieren zu können und zugleich eine flache Bauform des Fahrzeugzierteils zu erreichen, ist bei einer vorteilhaften Ausbildung vorgesehen, dass die Beleuchtungsschicht zumindest ein sich flächig entlang einer zu der Rückseite des Fahrzeugzierteils gewandten Seite der Sensorschicht erstreckendes Lichtleitelement aufweist und jedes Lichtleitelement jeweils von zumindest einem Beleuchtungselement beleuchtbar ist. Die Lichtleitelemente sind ausgebildet, ein von den Beleuchtungselementen bzw. ein von den jeweils zugeordneten Beleuchtungselementen abgestrahltes Licht in Richtung der Maskierungsschicht umzuleiten.

Die Beleuchtungselemente sind vorzugsweise LEDs, welche die Symbole als Farbwechsel-LEDs bzw. RGB-LEDs in mehreren Farben projizieren und die Anzeigefunktionalität mehrfarbig bereitstellen können. Die LEDs können als Top-LEDs und für eine flache Bauform der Beleuchtungsschicht vorzugsweise als Side-LEDs ausgebildet sein.

Die von den Beleuchtungsmitteln emittierten Lichtwellen verlaufen zunächst vorzugsweise parallel zu der Sensorschicht bzw. parallel zu der zu der Rückseite gewandten Seite der Sensorschicht, wobei die Lichtleitelemente ausgebildet sind, die Lichtwellen umzuleiten, so dass diese im Wesentlichen orthogonal auf die Maskierungsschicht treffen.

Zur Reflektion bzw. Umleitung der Lichtwellen sind die Lichtleitelemente vorzugsweise mit einer hellen, beispielsweise weißen, oder reflektierenden, beispielsweise silbrigen, Schicht bedampft bzw. beschichtet oder in ein helles oder reflektierendes Material eingebettet. Erstrecken sich die Lichtleitelemente in das Trägerelement hinein, ist vorzugsweise das Trägerelement in den die Lichtleitelemente aufnehmenden Bereichen mit einem hellen oder reflektierenden Material beschichtet oder aus diesem gebildet.

Vorzugweise weist die Beleuchtungsschicht mehrere Lichtleitelemente auf, welche beabstandet zueinander angeordnet sind. Um eine einheitliche Beleuchtungsschicht zu bilden ist vorgesehen, dass Bereiche zwischen den Lichtleitelementen mit einer Füllmasse verfüllt sind, so dass die Beleuchtungsschicht eine homogene Dicke aufweist.

Alternativ oder zusätzlich sieht eine vorteilhafte Variante vor, dass das Trägerelement an seiner zu der Sichtseite weisenden Seite zu den Lichtleitelementen und/oder Beleuchtungselementen korrespondierende Ausnehmungen aufweist, in welchen die Lichtleitelemente und/oder Beleuchtungselemente anordenbar sind, so dass sich die Lichtleitelemente und/oder die Beleuchtungselemente der Beleuchtungsschicht abschnittsweise in das Trägerelement hinein erstrecken.

Um eine flache Bauform des Fahrzeugzierteils zu gewährleisten, umfasst vorzugsweise keine der Schichten eine Ansteuerung oder ein Steuergerät. Eine vorteilhafte Weiterbildung sieht daher vor, dass die Sensorschicht und die Beleuchtungsschicht jeweils zumindest einen elektrischen Anschluss zum Anschluss an ein außerhalb des Fahrzeugzierteils anordenbares Steuergerät aufweisen und die Beleuchtungselemente durch den jeweiligen Anschluss ansteuerbar sowie die von der Sensorschicht erfasste Änderung durch den jeweiligen Anschluss auslesbar ist. Die Anschlüsse können, beispielsweise als Drähte, durch die Schichten in Richtung des Trägerelements bis auf die Rückseite des Fahrzeugzierteils durchgeführt sein.

Um eine scharfe und klare Darstellung der Symbole und zugleich eine hohe Berührungsempfindlichkeit der Sensorschicht zu gewährleisten, ist vorzugweise vorgesehen, dass eine zu der Sichtseite gewandte Oberfläche der Maskierungsschicht zwischen 0,10 und 2,00 mm, insbesondere zwischen 0,40 und 0,60 mm von einer zu der Sichtseite gewandten Oberfläche der Schutzschicht beabstandet ist und dass eine zu der Sichtseite gewandte Oberfläche der Beleuchtungsschicht zwischen 0,25 und 1,00 mm, insbesondere zwischen 0,30 mm und 0,50 mm von einer von der Sichtseite abgewandten Oberfläche der Maskierungsschicht beabstandet ist. Durch die geringen Abstände werden die Lichtstreuung und der Lichtverlust in den Schichten reduziert.

Insbesondere wird durch den geringen Abstand zwischen der Beleuchtungsschicht und der Maskierungsschicht gewährleistet, dass nur ein geringer Anteil des einem Symbol zugeordneten und von einem Beleuchtungselement emittierten Lichts als Streulicht in einem anderen Symbol sichtbar ist. Durch den geringen Abstand zwischen der Maskierungsschicht und der Oberfläche bzw. einem Abstand zwischen der Maskierungsschicht und der Zierschicht, welche vorzugsweise durch eine Klebeschicht beabstandet sind, wird das Symbol mit klaren und scharfen Kanten an die Zierschicht projiziert.

Die Zierschicht ist bei einer Ausführungsvariante eine bedruckte oder unbedruckte Schicht aus Holz, Papier, Metall oder Kunststoff, welche insbesondere eine Dicke zwischen 0,10 und 1,00 mm und vorzugsweise 0,40 und 0,50 mm aufweist, wobei ein optisches Erscheinungsbild einer zu der Sichtseite gewandten Seite der Zierschicht ein optisches Erscheinungsbild der Sichtseite des Fahrzeugzierteils bestimmt. Die Zierschicht kann beispielsweise auch aus Aluminium oder einer transparenten Kunststofffolie mit einer aufgedruckten oder aufgedampften Schicht gebildet sein. Hierzu kann als Zierschicht eine transparente Kunststofffolie mit aufgedampfter metallischer Schicht, insbesondere Aluminium, verwendet werden.

Die Zierschicht kann zudem auch transparent, teiltransparent oder perforiert ausgebildet sein, um eine Lichtdurchlässigkeit bereitzustellen. Bei einer Perforation kann diese auch ausschließlich im Bereich der darzustellenden Symbole ausgebildet sein.

Bei dem Herstellungsverfahren wird vorzugsweise zunächst der Schichtverbund gebildet. Der flexible Schichtverbund wird anschließend auf das Trägerelement aufgebracht und dabei verformt. Der Schichtverbund kann auf das Trägerelement aufgeklebt oder auflaminiert werden. Alternativ ist es auch möglich, dass der flexible Schichtverbund in eine Form eingelegt und das Trägerelement in der Form an den Schichtverbund angespritzt wird. Der Schichtverbund kann hierfür auch ohne die Beleuchtungsschicht verwendet werden, welche dann vor dem Aufkleben bzw. Auflaminieren oder vor dem Hinterspritzen auf bzw. mit dem Trägerelement hinzugefügt wird. Abschließend kann die Schutzschicht aufgetragen und insbesondere aufgespritzt oder der flexible Schichtverbund an der zu der Sichtseite gewandten Seite mit einem die Schutzschicht bildenden Lack übergossen werden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine Schnittansicht durch ein erstes Fahrzeugzierteil;
- Fig. 2: eine Schnittansicht durch ein zweites Fahrzeugzierteil;
- Fig. 3: eine Draufsicht auf ein Fahrzeugzierteil;
- Fig. 4a: Draufsicht auf ein Fahrzeugzierteil bei deaktivierter Anzeigefunktion;
- Fig. 4b: Draufsicht auf ein Fahrzeugzierteil bei aktivierter Anzeigefunktion.
- Fig. 4c: Rückansicht eines Fahrzeugzierteils ohne Trägerelement.

Die Figuren sind beispielhaft schematisch. Gleiche Bezugszeichen in den Figuren weisen auf gleiche funktionale und/oder strukturelle Merkmale hin.

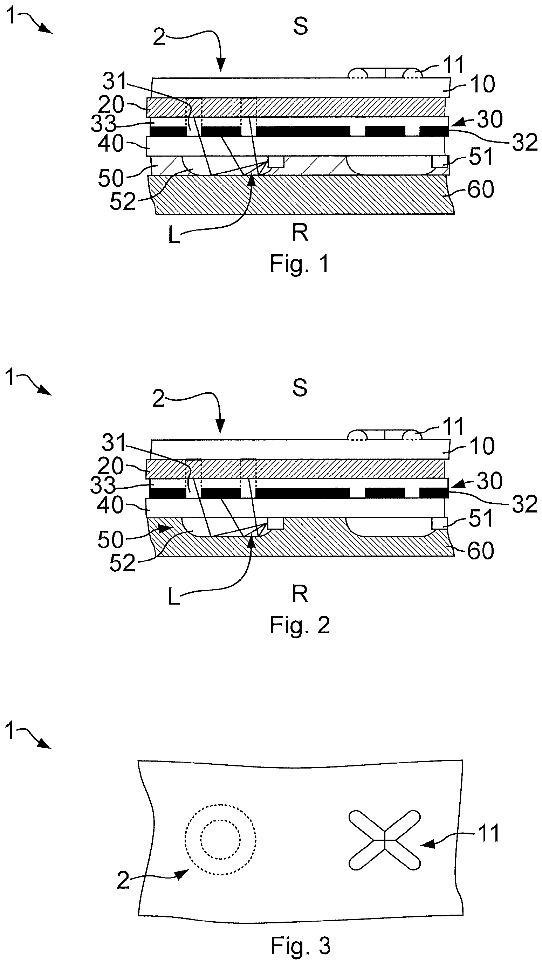

In Figur 1 ist ausschnittsweise eine schematische Schnittansicht durch ein Fahrzeugzierteil 1 dargestellt, welches hierfür von seiner Sichtseite S zu seiner Rückseite R eine Schutzschicht 10, eine Zierschicht 20, eine Maskierungsschicht 30, eine Sensorschicht 40, eine Beleuchtungsschicht 50 und ein Trägerelement 60 aufweist.

Die Schutzschicht 10 ist aus einem transparenten Lack gebildet und bedeckt die darunter liegende Zierschicht 20 zu der Sichtseite S hin, so dass die Zierschicht vor direkter Berührung und damit einhergehendem Verschleiß sowie Alterungserscheinungen, beispielsweise durch direkte Sonneneinstrahlung, geschützt ist. Darüber hinaus bildet die Schutzschicht 10 in der gezeigten Ausführungsform einen haptisch erstastbaren Vorsprung 11 aus. Alternativ zu dem Vorsprung 11 könnte der Bereich, in welchem in dem Ausführungsbeispiel der Vorsprung 11 angeordnet ist, haptisch erfassbar aufgeraut sein oder optisch erfassbar ein aufgedrucktes Symbol angeordnet sein.

Die Zierschicht 20 bestimmt die optische Erscheinung des Fahrzeugzierteils 1 und kann beispielsweise ein Holzfurnier sein, um dem Fahrzeugzierteil 1 das Erscheinungsbild eines Holzzierteils zu verleihen.

Unter der Zierschicht 20 bildet die Maskierungsschicht 30 durch intransparente Bereiche 32 und transparente Bereiche 31 eine Maske, wobei bei der dargestellten Variante zwischen der Maske und der Zierschicht 20 ein zu der Maskierungsschicht 30 gehörender und sich entlang der Zierschicht 20 erstreckender transparenter Bereich 33 angeordnet ist. Durch die Maske bzw. durch die transparenten Bereiche 31 werden Symbole bestimmt, welche ohne eine aktive Lichtquelle in der Beleuchtungsschicht 50 nicht von der Sichtseite S aus sichtbar sind.

Die Sensorschicht 40 ist ausgebildet, eine Berührung der oder Anäherung an die Schutzschicht 10 beispielsweise eines Finger zu erfassen und dadurch eine Bedienfunktion bereitzustellen. Insbesondere durch eine Berührung im Bereich des Vorsprungs 11 der Schutzschicht 10 kann beispielsweise, gesteuert durch ein nicht gezeigtes Steuergerät außerhalb des Fahrzeugzierteils 1, eine Anzeigefunktion des Fahrzeugzierteils 1 aktiviert werden.

Beispielsweise wird dazu der Vorsprung 11, der in dem Ausführungsbeispiel x-förmig ausgebildet ist, auch bereits bei ansonsten abgeschalteter Anzeigefunktion durch ein in der Beleuchtungsschicht 50 darunter liegendes Beleuchtungselement 51 bzw. das zu dem Beleuchtungselement 51 gehörende Lichtleitelement 52 und die zwischen Zierschicht 20 und Beleuchtungsschicht 50 liegende Maske beleuchtet, so dass der Vorsprung als Bedienelement zur Aktivierung der Anzeigefunktion durch Haptik und Beleuchtung schnell und einfach bedienbar ist.

Die einzelnen durch die Maske in der Maskierungsschicht 30 bestimmten Symbole können abhängig von einer anzuzeigenden Funktionalität durch die jeweils unter dem jeweiligen Symbol liegenden Beleuchtungselement 51 mit dem jeweils zugehörigen Lichtleitelement 52 beleuchtet und somit an der Zierschicht 20 sichtbar gemacht werden.

Die in der Beleuchtungsschicht 50 angeordneten Beleuchtungselemente sind vorzugsweise RGB-LEDs, welche als Side-LEDs ausgebildet sind, so dass das von Ihnen emittierte Licht parallel zu den Schichten ausgestrahlt wird. Die Lichtwellen werden durch die Lichtleitelemente 52 über die Fläche der jeweiligen Symbole verteilt und in Richtung der Maske bzw. der Maskierungsschicht umgeleitet, wie es durch die beispielhaften Lichtwellen L dargestellt ist.

Figur 2 zeigt eine zu der in Figur 1 gezeigten Variante alternative Ausführung eines Fahrzeugzierteils 1. Bei dem in Figur 2 dargestellten Fahrzeugzierteil 1 wird die Beleuchtungsschicht 50 nicht durch eine durchgehende, die Sensorschicht vollständig bedeckende Lage gebildet, sondern durch einzelne Bereiche oder Zellen, welche jeweils aus zumindest einem Lichtleitelement 52 mit zumindest einem Beleuchtungselement 51 gebildet sind. Diese stehen miteinander nicht unmittelbar sondern nur über das Trägerelelement 60 bzw. die Sensorschicht 40 in Verbindung. Die einzelnen Zellen bzw. die Lichtleitelemente 52 und die Beleuchtungselemente 51 sind in das Trägerelement 60 eingebettet, wodurch die Beleuchtungsschicht 50 bzw. die Zellen, welche die Beleuchtungsschicht 50 bilden in dem Trägerelement aufgenommen ist/sind. Die weiteren Merkmale entsprechen im Wesentlichen den Merkmalen des Fahrzeugzierteils 1, wie es in Figur 1 dargestellt ist.

In Figur 3 ist das Fahrzeugzierteil 1 aus Figur 1 oder aus Figur 2 aus einer Draufsicht von der Sichtseite aus gezeigt. Der Vorsprung 11 in x-Form ist haptisch ertastbar, wobei das o-förmige Symbol 2 nur sichtbar ist, wenn das darunter liegende Beleuchtungselement 51 zusammen mit dem zugehörigen Lichtleitelement 52 Lichtwellen emittiert und das Symbol an die zu der Rückseite R gewandte Seite der Zierschicht "wirft" bzw. projiziert. Das Symbol 2 kann dabei zugleich als Anzeigeelement dienen und beispielsweise anzeigen, dass eine Fahrzeugfunktion aktiviert ist, darüber hinaus dient das Symbol 2 zusammen mit dem Bereich der Sensorschicht 40 unterhalb des Symbols 2 zugleich als Bedienelement, da der Benutzer auf das Symbol 2 pressen bzw. dieses berühren kann und die so im Bereich des Symbols 2 aufgebrachte Berührung von der Sensorschicht 40 registriert und beispielsweise an das Steuergerät weitergegeben wird.

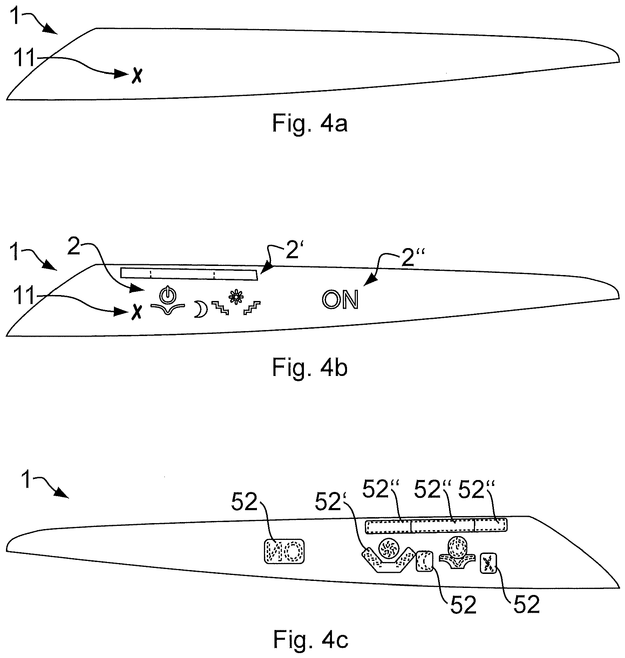

Die Figuren 4a und 4b zeigen ein Fahrzeugzierteil 1 bei aktivierter Anzeigefunktion und deaktivierter Anzeigefunktion, wobei das Fahrzeugzierteil 1 vorzugsweise mit dem in Figur 1 oder in Figur 2 gezeigten Schichtaufbau ausgebildet ist.

Bei dem Fahrzeugzierteil 1 in Figur 4a ist nur der Vorsprung 11 zu erkennen bzw. haptisch zu ertasten. Durch Berührung des Vorsprungs 11 wird der Druck oder die kapazitive Änderung von der Sensorschicht 40 erfasst und die erfasste Berührung als elektrisches Signal und vorzugsweise mit zugehörigen Koordinaten an ein Steuergerät weitergegeben, durch welches die Anzeigefunktion des Fahrzeugtierteils 1 aktiviert wird, so dass auf dem Fahrzeugzierteil 1 die in Figur 4b dargestellten Symbole sichtbar werden.

Durch die Symbole 2 können beispielsweise Bedienfunktionalitäten, wie die Aktivierung und Deaktivierung eines Tages- und Nachtmodus oder die Steuerung für einen Spiegel bereitgestellt werden, wobei jedes Symbol 2 von jeweils einem Beleuchtungselement 51 mit jeweils einem zugehörigen Lichtleitelement 52 beleuchtet und einzeln aktivier- oder deaktivierbar ist. Unter dem Symbol 2' liegen in der Beleuchtungsschicht drei Beleuchtungselemente 51 mit jeweils einem zugehörigen Lichtleitelement 52, so dass das Symbol 2' stufenweise aktivier- bzw. deaktivierbar ist und die Beleuchtung schrittweise zu- oder weggeschalten werden kann. Das Symbol 2" stellt beispielhaft einen Schriftzug "ON" dar, welcher alternativ aber auch eine andere Information, wie beispielsweise ein Hinweis oder eine Warnung, sein kann.

Wird die Anzeigefunktionalität, beispielsweise durch erneute Berührung des x-förmigen Vorsprungs 11 deaktiviert, werden die Beleuchtungselemente 11 deaktiviert, so dass die Symbole auf der Zierschicht 20 bzw. auf dem Fahrzeugzierteil 1 erneut nicht sichtbar sind.

Figur 4c zeigt die Rückansicht des Fahrzeugzierteils aus den Figur 4a und 4b ohne das Trägerelement 60, so dass die einzelnen Lichtleitelemente 52, 52', 52" sichtbar sind, welche im Bereich die Symbole 2, 2' und 2" angeordnet sind, um diese zusammen mit jeweils zumindest einem Beleuchtungselement zu beleuchten. Die einzelnen Lichtleitelemente 52, 52', 52" sind bei dem gezeigten Ausführungsbeispiel auf das jeweils zu beleuchtende Symbol 2, 2', 2" angepasst, wobei auch mehrere Symbole durch ein Lichtleitelement 52' beleuchtet werden können. Die unmittelbar aneinander angrenzenden Lichtleitelemente 52" sind vorzugsweise durch eine intransparente Schicht voneinander getrennt, so dass einzelne Segmente des zugehörigen Symbols 2' im Wesentlichen unabhängig voneinander beleuchtet werden können.

## Patentansprüche

1. Fahrzeugzierteil (1) mit integrierter Anzeige- und Bedienfunktion, umfassend ein rückseitiges Trägerelement (60) zur Befestigung des Fahrzeugzierteils (1) an einem Fahrzeug und eine transparente Schutzschicht (10), welche eine Außenfläche des Fahrzeugzierteils (1) und im bestimmungsgemäßen Gebrauch eine von dem Trägerelement (60) abgewandte Sichtseite (S) des Fahrzeugzierteils (1) bildet, wobei
zwischen der Schutzschicht (10) und dem Trägerelement (60) im Sandwichaufbau ausgehend von der Schutzschicht (10) zumindest eine lichtdurchlässige Zierschicht (20), eine Maskierungsschicht (30), eine transparente Sensorschicht (40) und eine Beleuchtungsschicht (50) angeordnet sind und wobei
die Maskierungsschicht (30) transparente Bereiche (31) aufweist,
die Beleuchtungsschicht (50) Beleuchtungselemente (51) umfasst und die Beleuchtungselemente (51) ausgebildet sind, die transparente Sensorschicht (40) und die transparenten Bereiche (31) der Maskierungsschicht (50) hin zu der Schutzschicht (10) zu durchleuchten und
die Sensorschicht (40) ausgebildet ist, eine von der Sichtseite (S) aus auf die Schutzschicht (10) aufgebrachte Berührung zu erfassen, so dass durch eine Durchleuchtung der Maskierungsschicht (30) mit den Beleuchtungselementen (51) die Anzeigefunktion und durch eine Erfassung der Berührung mit der Sensorschicht (40) die Bedienfunktion bereitstellbar sind
wobei die Maskierungsschicht (30) und die Sensorschicht (40) miteinander als eine flexible Folie ausgebildet sind, die Zierschicht (20) und die Beleuchtungsschicht (50) auf die Folie auflaminiert sind und ein so gebildeter Schichtverbund auf das Trägerelement (60) aufgeklebt oder mit dem Trägerelement (60) hinterspritzt ist.

2. Fahrzeugzierteil nach Anspruch 1, wobei
die Maskierungsschicht (30) intransparente Bereiche (32) aufweist und die intransparenten Bereiche (32) und transparenten Bereiche (31) der Maskierungsschicht eine Maske bilden, welche ein Negativ zumindest eines Symbols (2) bestimmt, wobei
durch die Durchleuchtung der Maske mit den Beleuchtungselementen (51) das Symbol (2) an eine zu der Rückseite (R) gewandten Seite der Zierschicht (20) projizierbar ist, wobei
das an die Rückseite der Zierschicht (20) projizierte Symbol (2) durch die Zierschicht (20) hindurch an einer zu der Sichtseite (S) weisenden Vorderseite der Zierschicht (20) sichtbar ist.

3. Fahrzeugzierteil nach Anspruch 2, wobei
die Maske das Negativ einer Vielzahl von Symbolen (2) bestimmt, die Symbole (2) verschiedene Anzeigeelemente bilden und eine im Bereich eines jeweiligen Symbols (2) von der Sichtseite (S) aus auf die Schutzschicht (10) aufgebrachte Berührung dem jeweiligen Symbol (2) und einer Bedienfunktion zuordenbar ist.

4. Fahrzeugzierteil nach Anspruch 2 oder 3, wobei
die Zierschicht (20) eine vorbestimmte Opazität aufweist, welche so gewählt ist, dass die transparenten Bereiche (31) der Maskierungsschicht (30) durch die Zierschicht (20) hindurch nicht von den intransparenten Bereichen (32) unterscheidbar sind, wenn die Beleuchtungselemente (51) die transparenten Bereiche (31) der Maskierungsschicht (30) nicht durchleuchten, so dass das Symbol (2) oder die Symbole (2), die durch die Maske der Maskierungsschicht (30) bestimmt sind, ohne eine Durchleuchtung der Maskierungsschicht (30) mit den Beleuchtungselementen (51) von der Sichtseite (S) aus nicht sichtbar sind.

5. Fahrzeugzierteil nach einem der vorhergehenden Ansprüche, wobei
die Schutzschicht (10) einen sich zu der Sichtseite (S) hin erstreckenden und haptisch oder optisch erfassbaren Vorsprung (11) oder Bereich ausbildet.

6. Fahrzeugzierteil nach einem der vorhergehenden Ansprüche, wobei
die Sensorschicht (40) ausgebildet ist, einen Bereich, in dem die Berührung aufgebracht wird, zu erfassen.

7. Fahrzeugzierteil nach einem der vorhergehenden Ansprüche, wobei
die Sensorschicht (40) ausgebildet ist, die Berührung durch einen über die Schutzschicht (10) auf die Sensorschicht (40) aufgebrachten Druck oder durch eine kapazitive Änderung in einem zur Sichtseite (S) an die Schutzschicht (10) angrenzenden Nahbereich zu erfassen.

8. Fahrzeugzierteil nach einem der vorhergehenden Ansprüche, wobei
die Beleuchtungsschicht (50) zumindest ein sich flächig entlang einer zu der Rückseite (R) des Fahrzeugzierteils (1) gewandten Seite der Sensorschicht (40) erstreckendes Lichtleitelement (52) aufweist und jedes Lichtleitelement (52) jeweils von zumindest einem Beleuchtungselement (51) beleuchtbar ist, wobei
die Lichtleitelemente (52) ausgebildet sind, ein von den Beleuchtungselementen (51) abgestrahltes Licht in Richtung der Maskierungsschicht (30) umzuleiten.

9. Fahrzeugzierteil nach dem vorhergehenden Anspruch, wobei
die Beleuchtungsschicht (50) mehrere Lichtleitelemente (52) aufweist, welche beabstandet zueinander angeordnet sind, wobei
Bereiche zwischen den Lichtleitelementen (52) mit einer Füllmasse verfüllt sind, so dass die Beleuchtungsschicht (50) eine homogene Dicke aufweist.

10. Fahrzeugzierteil nach dem vorhergehenden Anspruch 8 oder 9, wobei
das Trägerelement (60) an seiner zu der Sichtseite (S) weisenden Seite zu den Lichtleitelementen (52) und/oder Beleuchtungselementen (51) korrespondierende Ausnehmungen aufweist, in welchen die Lichtleitelemente (52) und/oder Beleuchtungselemente (51) anordenbar sind, so dass sich die Lichtleitelemente (52) und/oder die Beleuchtungselemente (51) der Beleuchtungsschicht (50) abschnittsweise in das Trägerelement (60) hinein erstrecken.

11. Fahrzeugzierteil nach einem der vorhergehenden Ansprüche, wobei
die Sensorschicht (40) und die Beleuchtungsschicht (50) jeweils zumindest einen elektrischen Anschluss zum Anschluss an ein außerhalb des Fahrzeugzierteils (1) anordenbares Steuergerät aufweisen und
die Beleuchtungselemente (51) durch den jeweiligen Anschluss ansteuerbar sowie die von der Sensorschicht (40) erfasste Berührung durch den jeweiligen Anschluss auslesbar ist.

12. Fahrzeugzierteil nach einem der vorhergehenden Ansprüche, wobei
eine zu der Sichtseite (S) gewandte Oberfläche der Maskierungsschicht (30) zwischen 0,10 und 2,00 mm, insbesondere zwischen 0,40 und 0,60 mm, von einer zu der Sichtseite (S) gewandten Oberfläche der Schutzschicht (10) beabstandet ist und
eine zu der Sichtseite (S) gewandte Oberfläche der Beleuchtungsschicht (50) zwischen 0,25 und 1,00 mm, insbesondere zwischen 0,30 mm und 0,50 mm, von einer von der Sichtseite abgewandten Oberfläche der Maskierungsschicht (30) beabstandet ist.

13. Fahrzeugzierteil nach einem der vorhergehenden Ansprüche, wobei
die Zierschicht (20) eine bedruckte oder unbedruckte Schicht aus Holz, Papier, Metall oder Kunststoff ist und ein optisches Erscheinungsbild einer zu der Sichtseite (S) gewandten Seite der Zierschicht (20) ein optisches Erscheinungsbild der Sichtseite (S) des Fahrzeugzierteils (1) bestimmt.

## Claims

1. Vehicle trim part (1) with an integrated display and operating function, comprising a rear carrier element (60) for fastening the vehicle trim part (1) to a vehicle, and a transparent protective layer (10) which covers an outer surface of the vehicle trim part (1) and in the intended use forms a visible side (S) of the vehicle trim part (1) facing away from the carrier element (60), wherein
at least one translucent decorative layer (20), one masking layer (30), one transparent sensor layer (40), and one lighting layer (50) are sandwiched between the protective layer (10) and the carrier element (60) starting from the protective layer (10), and wherein
the masking layer (30) includes transparent areas (31),
the lighting layer (50) comprises lighting elements (51) and the lighting elements (51) are designed to transilluminate the transparent sensor layer (40) and the transparent areas (31) of the masking layer (50) towards the protective layer (10), and the sensor layer (40) is designed to detect a contact applied to the protective layer (10) from the visible side (S), so that the display function can be activated by transilluminating the masking layer (30) using the lighting elements (51), and the operating function can be provided by detecting the contact using the sensor layer (40),
wherein the masking layer (30) and the sensor layer (40) are formed with one another as a flexible film, the decorative layer (20) and the lighting layer (50) are laminated onto the film, and a layer composite thus formed is adhesively bonded onto the carrier element (60) or is back-injected with the carrier element (60).

2. The vehicle trim part according to claim 1, wherein
the masking layer (30) includes nontransparent areas (32) and
the nontransparent areas (32) and transparent areas (31) of the masking layer form a mask which defines a negative of at least one symbol (2), wherein
by transilluminating the mask using the lighting elements (51), the symbol (2) can be projected onto a side of the decorative layer (20) facing toward the rear (R), wherein
the symbol (2) projected onto the rear of the decorative layer (20) is visible through the decorative layer (20) on a front side of the decorative layer (20) facing toward the visible side (S) .

3. The vehicle trim part according to claim 2, wherein
the mask defines the negative of a plurality symbols (2), the symbols (2) form different display elements, and a contact applied to the protective layer (10) from the visible side (S) in the area of a respective symbol (2) can be attributed to the respective symbol (2) and an operating function.

4. The vehicle trim part according to claim 2 or 3, wherein the decorative layer (20) has a predetermined opacity, which is selected so that the transparent areas (31) of the masking layer (30) are not distinguishable from the non-transparent areas (32) through the decorative layer (20) when the lighting elements (51) do not transilluminate the transparent areas (31) of the masking layer (30), so that the symbol (2) or the symbols (2), which are defined by the mask of the masking layer (30), are not visible from the visible side (S) without the lighting elements (51) transilluminating the masking layer (30).

5. The vehicle trim part according to any one of the preceding claims, wherein
the protective layer (10) forms a protrusion (11) or area which extends towards the visible side (S) and is detectable haptically or optically.

6. The vehicle trim part according to any one of the preceding claims, wherein
the sensor layer (40) is designed to detect an area in which the contact is applied.

7. The vehicle trim part according to any one of the preceding claims, wherein
the sensor layer (40) is designed to detect the contact by pressure applied to the sensor layer (40) via the protective layer (10) or by a capacitive change in an adjacent area adjoining the protective layer (10) on the visible side (S).

8. The vehicle trim part according to any one of the preceding claims, wherein
the lighting layer (50) has at least one light-guiding element (52) that extends flatly along a side of the sensor layer (40) that faces toward the rear (R) of the vehicle trim part (1), and each light-guiding element (52) can be illuminated by at least one lighting element (51), wherein
the light-guiding elements (52) are designed to redirect light emitted by the lighting elements (51) in the direction of the masking layer (30).

9. The vehicle trim part according to the preceding claim, wherein
the lighting layer (50) includes multiple light-guiding elements (52) which are arranged spaced apart from one another, wherein areas between the light-guiding elements (52) are filled using a filling compound, so that the lighting layer (50) has a homogeneous thickness.

10. The vehicle trim part according to preceding claim 8 or 9, wherein
the carrier element (60), on its side facing toward the visible side (S), has corresponding recesses for the light-guiding elements (52) and/or lighting elements (51), in which the light-guiding elements (52) and/or lighting elements (51) can be arranged so that the light-guiding elements (52) and/or the lighting elements (51) of the lighting layer (50) extend in sections into the carrier element (60).

11. The vehicle trim part according to any one of the preceding claims, wherein
the sensor layer (40) and the lighting layer (50) each include at least one electrical connection for connection to a control unit that can be arranged outside the vehicle trim part (1), and the lighting elements (51) can be controlled by the respective connection and the contact detected by the sensor layer (40) can be read by the respective connection.

12. The vehicle trim part according to any one of the preceding claims, wherein
a surface of the masking layer (30) facing toward the visible side (S) is spaced apart between 0.10 and 2.00 mm, in particular between 0.40 and 0.60 mm, from a surface of the protective layer (10) facing toward the visible side (S), and
a surface of the lighting layer (50) facing toward the visible side (S) is spaced apart between 0.25 and 1.00 mm, in particular between 0.30 mm and 0.50 mm, from a surface of the masking layer (30) facing away from the visible side.

13. The vehicle trim part according to any one of the preceding claims, wherein
the decorative layer (20) is a printed or unprinted layer made of wood, paper, metal, or plastic, and a visual appearance of a side of the decorative layer (20) facing toward the visible side (S) determines a visual appearance of the visible side (S) of the vehicle trim part (1).

## Revendications

1. Élément de garnissage de véhicule (1) à fonction d'affichage et de commande intégrée, comprenant un élément de support arrière (60) pour la fixation de l'élément de garnissage de véhicule (1) sur un véhicule, et une couche de protection transparente (10) qui forme une surface extérieure de l'élément de garnissage de véhicule (1) et, en cas d'usage conforme, un côté visible (S) de l'élément de garnissage de véhicule (1) opposé à l'élément de support (60), dans lequel au moins une couche de garnissage transparente (20), une couche de masquage (30), une couche de capteur transparente (40) et une couche d'éclairage (50) sont disposées entre la couche de protection (10) et l'élément de support (60) dans une structure en sandwich, en partant de la couche de protection (10) et dans lequel
la couche de masquage (30) présente des zones transparentes (31),
la couche d'éclairage (50) comprend des éléments d'éclairage (51) et les éléments d'éclairage (51) sont conçus pour éclairer la couche de capteur transparente (40) et les zones transparentes (31) de la couche de masquage (50) jusqu'à la couche de protection (10) et
la couche de capteur (40) est conçue pour détecter un contact appliqué sur la couche de protection (10) à partir du côté visible (S), de sorte que la fonction d'affichage peut être activée par l'éclairage de la couche de masquage (30) avec les éléments d'éclairage (51) et la fonction de commande activée par une détection du contact avec la couche de capteur (40),
dans lequel la couche de masquage (30) et la couche de capteur (40) sont formées ensemble sous la forme d'un film flexible, la couche de garnissage (20) et la couche d'éclairage (50) sont laminées sur le film et un composite stratifié ainsi formé est collé sur l'élément de support (60) ou injecté par l'arrière avec l'élément de support (60).

2. Élément de garnissage de véhicule selon la revendication 1, dans lequel
la couche de masquage (30) présente des zones non transparentes (32) et les zones non transparentes (32) et les zones transparentes (31) de la couche de masquage forment un masque qui détermine un négatif d'au moins un symbole (2), dans lequel, en éclairant le masque avec les éléments d'éclairage (51), le symbole (2) peut être projeté sur une face de la couche de garnissage (20) tournée vers la face arrière (R), dans lequel le symbole (2) projeté sur la face arrière de la couche de garnissage (20) est visible à travers la couche de garnissage (20) sur une face avant de la couche de garnissage (20) orientée vers le côté visible (S).

3. Élément de garnissage de véhicule selon la revendication 2, dans lequel
le masque détermine le négatif d'une pluralité de symboles (2), les symboles (2) forment différents éléments d'affichage, et un contact appliqué sur la couche de protection (10) dans la zone d'un symbole (2) respectif depuis le côté visible (S) peut être attribué au symbole respectif (2) et à une fonction de commande.

4. Élément de garnissage de véhicule selon la revendication 2 ou 3, dans lequel
la couche de garnissage (20) présente une opacité prédéterminée, qui est choisie de sorte que les zones transparentes (31) de la couche de masquage (30) ne peuvent pas être distinguées des zones non transparentes (32) à travers la couche de garnissage (20) lorsque les éléments d'éclairage (51) n'éclairent pas les zones transparentes (31) de la couche de masquage (30), afin que le symbole (2) ou les symboles (2), qui sont déterminés par le masque de la couche de masquage (30) ne soient pas visibles depuis le côté visible (S) sans éclairer la couche de masquage (30) avec les éléments d'éclairage (51).

5. Élément de garnissage de véhicule selon l'une des revendications précédentes, dans lequel
la couche de protection (10) forme une saillie (11) ou une zone qui s'étend vers le côté visible (S) et peut être détectée de manière haptique ou optique.

6. Élément de garnissage de véhicule selon l'une des revendications précédentes, dans lequel
la couche de capteur (40) est conçue pour détecter une zone dans laquelle le contact est appliqué.

7. Élément de garnissage de véhicule selon l'une des revendications précédentes, dans lequel
la couche de capteur (40) est conçue pour détecter le contact par une pression appliquée sur la couche de capteur (40) via la couche de protection (10) ou par un changement capacitif dans une zone proche adjacente à la couche de protection (10) sur le côté visible (S).

8. Élément de garnissage de véhicule selon l'une des revendications précédentes, dans lequel
la couche d'éclairage (50) présente au moins un élément de guidage de lumière (52) qui s'étend à plat le long d'un côté de la couche de capteur (40) tourné vers la face arrière (R) de l'élément de garnissage de véhicule (1), et chaque élément de guidage de lumière (52) peut être éclairé respectivement par au moins un élément d'éclairage (51), dans lequel
les éléments de guidage de lumière (52) sont conçus pour rediriger la lumière émise par les éléments d'éclairage (51) en direction de la couche de masquage (30).

9. Élément de garnissage de véhicule selon la revendication précédente, dans lequel
la couche d'éclairage (50) présente plusieurs éléments conducteurs de lumière (52) disposés à distance les uns des autres, dans lequel
des zones entre les éléments de guidage de lumière (52) sont recouvertes d'un composé de remplissage de sorte que la couche d'éclairage (50) présente une épaisseur homogène.

10. Élément de garnissage de véhicule selon la revendication précédente 8 ou 9, dans lequel
l'élément de support (60) présente, sur sa face orientée vers le côté visible (S), des évidements correspondants aux éléments de guidage de lumière (52) et/ou aux éléments d'éclairage (51), dans lesquels les éléments de guidage de lumière (52) et/ou les éléments d'éclairage (51) peuvent être agencés de sorte que les éléments de guidage de lumière (52) et/ou les éléments d'éclairage (51) de la couche d'éclairage (50) s'étendent par sections dans l'élément de support (60).

11. Élément de garnissage de véhicule selon l'une des revendications précédentes, dans lequel
la couche de capteur (40) et la couche d'éclairage (50) présentent chacune au moins une connexion électrique pour le raccordement à un appareil de commande qui peut être disposé à l'extérieur de l'élément de garnissage de véhicule (1) et
les éléments d'éclairage (51) peuvent être commandés par la connexion respective, et le contact détecté par la couche de capteur (40) peut être lu par la connexion respective.

12. Élément de garnissage de véhicule selon l'une des revendications précédentes, dans lequel
une surface de la couche de masquage (30) tournée vers le côté visible (S) est espacée entre 0,10 et 2,00 mm, en particulier entre 0,40 et 0,60 mm, d'une surface de la couche de protection (10) tournée vers le côté visible (S) et
une surface de la couche d'éclairage (50) tournée vers le côté visible (S) est espacée entre 0,25 et 1,00 mm, en particulier entre 0,30 mm et 0,50 mm, d'une surface de la couche de masquage (30) opposée au côté visible.

13. Élément de garnissage de véhicule selon l'une des revendications précédentes, dans lequel
la couche de garnissage (20) est une couche imprimée ou non imprimée en bois, papier, métal ou plastique et un aspect visuel d'une face de la couche de garnissage (20) tournée vers le côté visible (S) détermine un aspect du côté visible (S) de l'élément de garnissage de véhicule (1).
